# EUROPEAN PATENT APPLICATION

(11) **EP 4 597 500 A1**
(43) Date of publication of application: **06.08.2025**
(21) Application number: 24220931.0
(22) Date of filing: 18.12.2024
(51) Int. Cl.: G11C 11/405, G11C 11/409, G11C 11/4094, H10B 12/00

(54) **2T0C-BASED MEMORY CELL AND OPERATING METHOD THEREOF**

(30) Priority: 30.01.2024 KR 20240014361; 03.12.2024 KR 20240177828
(71) Applicant: UIF (University Industry Foundation), Yonsei University, Seoul 03722 (KR)
(72) Inventor: KIM, Hyun Jae, 04094 Seoul (KR); PARK, Kyungho, 10418 Gyeonggi-do (KR); AN, Jong Bin, 06006 Seoul (KR); CHUNG, Jusung, 03721 Seoul (KR); CHOI, Dong Hyun, 03783 Seoul (KR); KWAK, Kyungmoon, 02807 Seoul (KR); SEO, You Jin, 03726 Seoul (KR); KIM, Beom Soo, 06509 Seoul (KR); LEE, Moon Ho, 03787 Seoul (KR); MOON, Kunho, 03727 Seoul (KR)
(74) Representative: Jung, Minkyu

(57) **Abstract**

The present disclosure relates to a 2T0C-based memory cell. The 2T0C-based memory cell includes a first transistor and a second transistor connected through a storage node, a first word line connected to the first transistor and controlling an on/off state of the first transistor through an operation of applying a voltage, a second word line connected to the second transistor and controlling an on/off state of the second transistor such that data stored in the memory cell are read, and a single bit line connected to the first transistor and the second transistor and allowing the storage node to be charged or discharged depending on a voltage applied to the single bit line.

## Description

### CROSS-REFERENCE TO RELATED APPLICATIONS

A claim for priority under 35 U.S.C. § 119 is made to Korean Patent Application No. 10-2024-0014361 filed on January 30, 2024 and No. 10-2024-0177828 filed on December 03, 2024, in the Korean Intellectual Property Office, the entire contents of which are hereby incorporated by reference.

### BACKGROUND

Embodiments of the present disclosure described herein relate to a 2T0C-based memory cell and an operating method thereof, and more particularly, relate to a 2T0C-based memory cell for improving the degree of integration of a memory cell and an operating method thereof.

The present disclosure is derived from research conducted as part of the core technology development of the National Semiconductor Research Laboratory (NSL) of the Ministry of Science and ICT (Project Unique Number: 1711197801, Project Number: 00256917, Research Project Name: Development of IGZO V-Tr-based High-Integrated/High-Performance Capacitorless DRAM Technology for Next-Generation Neuromorphic Computing Systems, Project Management Agency: National Research Foundation of Korea, Project Execution Agency: Yonsei University Industry-Academic Cooperation Foundation, Research Period: 2023.05.01 ~ 2024.01.31). Meanwhile, there is no property interest of the Korean government in any aspect of the present disclosure.

Unlike an existing memory cell including one transistor and one capacitor, a 2T0C-based memory cell refers to a memory cell including two transistors without a capacitor. For example, the 2T0C-based memory cell may store data by using a parasitic capacitance formed by the two transistors.

Meanwhile, as technologies such as on-device AI develop, various studies are being conducted to miniaturize (or scale down) a semiconductor chip and to improve the degree of integration of a memory cell. However, because the existing 2T0C-based memory cell is configured to necessarily include two bit lines and two word lines, it is difficult to reduce the feature size indicating the dimensions of the memory cell.

### SUMMARY

Embodiments of the present disclosure provide a 2T0C-based memory cell, an operating method thereof, a computer program stored in a computer-readable medium, a computer-readable medium in which the computer program is stored, and a device (system).

The present disclosure may be implemented by various manners including a method, a device (system), a computer program stored in a computer-readable medium, or a computer-readable medium in which the computer program is stored.

According to an embodiment of the present disclosure, a 2T0C-based memory cell may include a first transistor and a second transistor connected through a storage node, a first word line connected to the first transistor and controlling an on/off state of the first transistor through an operation of applying a voltage, a second word line connected to the second transistor and controlling an on/off state of the second transistor such that data stored in the memory cell are read, and a single bit line connected to the first transistor and the second transistor and allowing the storage node to be charged or discharged depending on a voltage applied to the single bit line.

In addition, when the first transistor is controlled by the first word line so as to be set to the on state and a first voltage is provided through the single bit line, first data may be stored by charges charged on the storage node.

Also, the first data stored on the storage node may be maintained when the first transistor is controlled by the first word line so as to be set to the off state.

Furthermore, when a second voltage is provided through the single bit line and the second voltage is provided through the second word line, the second transistor may operate, and the first data may be read by sensing a voltage value of the second transistor through the single bit line.

Besides, when the first transistor is controlled by the first word line so as to be set to the on state and a second voltage is provided through the single bit line, charges on the storage node may be discharged such that second data are stored.

In addition, when the first transistor is controlled by the first word line so as to be set to the off state and a first voltage is applied to the second word line, the second data stored on the storage node may be maintained.

Also, when the second voltage is provided through the single bit line and the second voltage is provided through the second word line, the second transistor may operate, and the second data may be read by sensing a voltage value of the single bit line.

Furthermore, the memory cell may have a feature size smaller than a memory cell using two bit lines by using single bit line.

Besides, the memory cell may have a feature size of 12*F*² per bit by using the single bit line.

In addition, the memory cell may be capable of being stacked in a plurality of layers within a range of the feature size.

Also, the memory cell may be capable of being stacked in two layers within a range of the feature size of 12*F*² per bit, and the 2T0C-based memory cell may have a feature size of 6*F*² per bit.

Furthermore, the memory cell may be capable of being stacked in three layers within a range of the feature size of 12*F*² per bit, and the 2T0C-based memory cell may have a feature size of 4*F*² per bit.

Besides, the first transistor or the second transistor may include a channel formed of at least one of oxide and organic semiconductor.

In addition, the first transistor or the second transistor may include an insulator formed of at least some *AIOₓ*, *HfOₓ*, *SiOₓ*, and *HfZrOₓ.*

According to an embodiment of the present disclosure, an operating method of a 2T0C-based memory cell which is performed by at least one processor includes controlling a first transistor based on a first word line so as to be set to an on state, applying a first voltage to a single bit line such that charges are charged on a storage node, first data being stored by the charges on the storage node, controlling the first transistor based on the first word line so as to be set to an off state, wherein a charging state of the storage node is maintained when the first transistor is in the off state, and reading the first data by sensing a voltage value of the single bit line after applying a second voltage to the single bit line and applying the second voltage to a second word line such that a second transistor connected to the storage node operates.

In addition, the reading of the first data may include reading the first data by sensing the voltage value of the single bit line based on the operation of the second transistor in a state where the charges are charged on the storage node.

Also, the method may further include controlling the first transistor based on the first word line so as to be set to the on state when a charging state of the storage node is maintained, storing second data by applying the second voltage to the single bit line such that the charges on the storage node are discharged, controlling the first transistor based on the first word line so as to be set to the off state, a discharging state of the storage node being maintained when the first transistor is in the off state, and reading the second data by sensing a voltage value of the single bit line after applying the second voltage to the single bit line and applying the second voltage to the second word line such that the second transistor connected to the storage node operates.

A computer program stored in a non-transitory recording medium readable by a computer to execute the method according to an embodiment of the present disclosure on the computer is provided.

### BRIEF DESCRIPTION OF THE FIGURES

Embodiments of the present disclosure will be described with reference to accompanying drawings to be described blow, in which similar reference numerals indicate, but are not limited to, similar elements.
FIG. 1 is a diagram illustrating a circuit structure of a 2T0C-based memory cell according to an embodiment of the present disclosure.
FIG. 2 is a diagram illustrating a process in which a memory cell operates when first data are written or read, according to an embodiment of the present disclosure.
FIG. 3 is a diagram illustrating a process in which a memory cell operates when second data are written or read, according to an embodiment of the present disclosure.
FIGS. 4A and 4B are views illustrating top-view images of a 2T0C-based memory cell according to an embodiment of the present disclosure.
FIG. 5 is a diagram of 2T0C-based memory cells stacked in two layers, according to an embodiment of the present disclosure.
FIG. 6 is a diagram of 2T0C-based memory cells stacked in three layers, according to an embodiment of the present disclosure.
FIG. 7 is a table illustrating a feature size of 2T0C-based memory cells stacked in a plurality of layers and an effect for the number of layers, according to an embodiment of the present disclosure.
FIG. 8 is a flowchart illustrating an example of an operating method of a 2T0C-based memory cell according to an embodiment of the present disclosure.
FIG. 9 is a block diagram illustrating an internal configuration of a computing device according to an embodiment of the present disclosure.

### DETAILED DESCRIPTION

Below, the detailed description for carrying out the present disclosure will be given with reference to the accompanying drawings. However, in the following description, detailed descriptions of well-known functions or configurations will be omitted when it may make the subject matter of the present disclosure rather unclear.

In the accompanying drawings, the same or corresponding components are given the same reference numerals. In addition, in the following description of embodiments, duplicate descriptions of the same or corresponding components may be omitted. However, even though descriptions of components are omitted, it is not intended that such components are not included in any embodiment.

Advantages and features of the disclosed embodiments, and methods of accomplishing the same will be apparent by referring to embodiments described below in connection with the accompanying drawings. However, the present disclosure is not limited to the embodiments disclosed below, and may be implemented in various different forms, and the embodiments are merely provided to make the present disclosure complete, and to fully disclose the scope of the invention to one skilled in the art to which the present disclosure pertains.

The terms used herein will be briefly described prior to describing the disclosed embodiments in detail. The terms used herein have been selected as general terms which are widely used at present in consideration of the functions of the present disclosure, and this may be altered according to the intent of an operator skilled in the art, conventional practice, or introduction of new technology. In addition, in a specific case, a term is arbitrarily selected by the applicant, and the meaning of the term will be described in detail in a corresponding description of the embodiments. Therefore, the terms used in the present disclosure should be defined based on the meaning of the terms and the overall contents of the present disclosure rather than a simple name of each of the terms.

As used herein, the singular forms "a", "an", and "the" are intended to include the plural forms as well, unless the context clearly indicates the singular forms. Further, the plural forms are intended to include the singular forms as well, unless the context clearly indicates the plural forms. Further, throughout the description, when a portion is stated as "comprising (including)" a component, it intends to mean that the portion may additionally comprise (or include or have) another component, rather than excluding the same, unless specified to the contrary.

In the present disclosure, the term "include" or "comprise" may refer to the presence of features, steps, operations, elements, and/or components, but the term does not preclude the addition of one or more other functions, steps, operations, elements, components, and/or a combination thereof.

In the present disclosure, when a particular component is referred to as "coupled", "combined", or "connected" to any other component or as "reacting" with any other component, the particular component may be directly coupled, combined, and/or connected to another component or may react with another component. However, the present disclosure is not limited thereto. For example, one or more intermediate components may be present between a particular component and another component. In addition, in the present disclosure, "and/or" may include each of one or more items listed or a combination of at least some of the one or more items.

In the present disclosure, the terms "first" and "second" are used to distinguish specific components from other components, and the above components are not limited by these terms. For example, the "first" component may be an element of the same or similar form as the "second" component.

In the present disclosure, unlike an existing memory cell including one transistor and one capacitor, a "2T0C-based memory cell" may refer to a memory cell including two transistors without a capacitor. For example, the 2T0C-based memory cell may store data by using a parasitic capacitance formed by the two transistors.

In the present disclosure, a "transistor" may refer to an element which adjusts a flow of a current or a voltage so as to be amplified or serves as a switch and may include, for example, a metal oxide semiconductor field effect transistor (MOSFET).

In the present disclosure, a "storage node" may refer to a parasitic capacitor formed between two transistors and may be used to store data through charging or discharging.

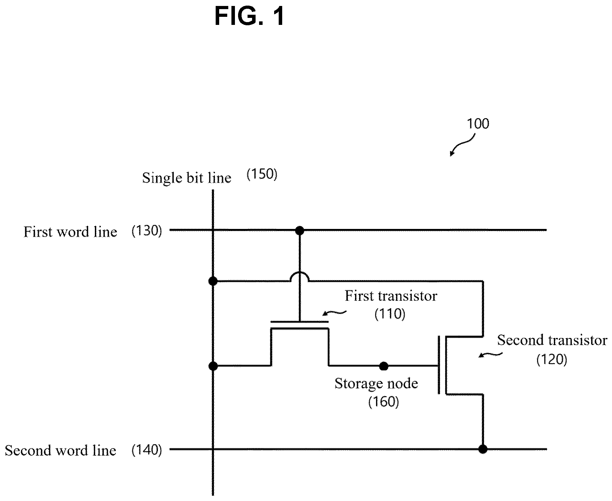

FIG. 1 is a diagram illustrating a circuit structure of a 2T0C-based memory cell 100 according to an embodiment of the present disclosure. According to an embodiment, the 2T0C-based memory cell 100 may refer to a memory cell which operates by using two transistors without a capacitor. For example, the 2T0C-based memory cell 100 may write or read data by using a parasitic capacitor, which is formed by the two transistors, as a storage node.

As illustrated, the memory cell 100 may include a first transistor 110 and a second transistor 120 connected through a storage node 160. Also, the memory cell 100 may include a first word line 130 connected to the first transistor 110 and a second word line 140 connected to the second transistor 120. In this case, unlike a typical memory cell having two bit lines, the memory cell 100 may include only a single bit line 150 for storing data.

According to an embodiment, the first word line 130 may be used to control an on/off state of the first transistor 110. For example, when a bias voltage is applied through the first word line 130, the state of the first transistor 110 may transition to the on state, and thus, a channel may be formed. Also, when a voltage is not applied through the first word line 130, the state of the first transistor 110 may transition to the off state, and thus, the channel may be shut off. That is, a transfer path of charges passing through the first transistor 110 may be formed or blocked by the first word line 130.

According to an embodiment, the second word line 140 may be used to change a source/drain voltage of the second transistor 120 such that the stored data are read by the single bit line 150 through the operation of the second transistor 120. In detail, the second word line 140 may contribute to reading the stored data of the memory cell 100 based on whether the storage node 160 is charged or discharged. For example, because the second transistor 120 operates in a state where charges are charged at the storage node 160, the second word line 140 may contribute to an operation of reading that data "1" are stored; when there is a state where charges on the storage node 160 are discharged, the second word line 140 may contribute to an operation of reading that data "0" are stored.

According to an embodiment, the single bit line 150 may be connected to the first transistor 110 and the second transistor 120. A direction in which charges pass through the second transistor 120 may be changed by adjusting a voltage to be applied to the single bit line 150, and thus, the storage node 160 may be charged or discharged. Also, as the voltage to be applied to the single bit line 150 is adjusted, a potential difference of the single bit line 150 and the second word line 140, which are connected with the second transistor 120 interposed therebetween, may be changed, and thus, a voltage value of the single bit line 150 may be sensed or may not be sensed by the second transistor 120 operating.

An example in which one memory cell 100 is connected through the first word line 130, the second word line 140, and the single bit line 150 is illustrated in FIG. 1, but the present disclosure is not limited thereto. For example, the memory cell 100 may share the first word line 130, the second word line 140, and the single bit line 150 with another memory cell adjacent thereto. According to the above configuration, the memory cell 100 may adjust the charging or discharging state of the storage node 160 only by using the single bit line 150 or may accurately form the potential difference with the second word line 140 to perform the efficient control.

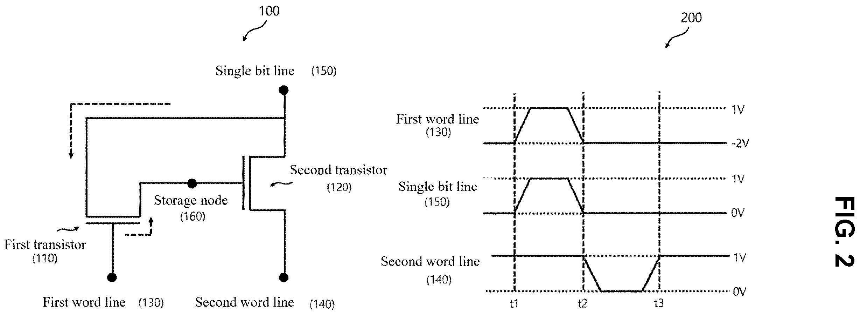

FIG. 2 is a diagram illustrating a process in which the memory cell 100 operates when first data are written or read, according to an embodiment of the present disclosure. In the illustrated example, a graph 200 may show changes of voltages of the first word line 130, the second word line 140, and the single bit line 150 over time.

According to an embodiment, in a time period from t1 to t2, an operation in which first data (e.g., data "1") are written in the memory cell 100 may be performed. Referring to the graph 200, a voltage of 1 V may be applied to the first word line 130. In this case, the first transistor 110 may change to the on state to form a charge transfer path. Also, the voltage of 1 V (e.g., a first voltage) may be applied to the single bit line 150. In this case, charges of the single bit line 150 may move to the storage node 160 through the first transistor 110 so as to be accumulated. According to the above description, the first data may be stored in the memory cell 100 by charging charges on the storage node 160.

According to an embodiment, in a time period from t2 to t3, the first data stored in the memory cell 100 may be maintained. Referring to the graph 200, the voltage applied to the first word line 130 may be changed from 1 V to -2 V. In this case, the first transistor 110 may change to the off state to block the charge transfer path.

Also, the voltage applied to the second word line 140 may be changed from 1 V to 0 V. In this case, because a source-drain potential difference of the second transistor 120 is not maintained, the second transistor 120 may block the charge transfer path.

When the charge transfer path is blocked as described above, the storage node 160 may remain in a state where charges are charged, and thus, there may be maintained a state where the first data are stored in the memory cell 100.

According to an embodiment, in a time period following t3, an operation of reading the first data stored in the memory cell 100 may be performed. Referring to the graph 200, the voltage applied to the single bit line 150 may be changed from 1 V to 0 V. Also, the voltage applied to the second word line 140 may be changed from 0 V to 1 V. As described above, as the voltage of 0 V (e.g., a second voltage) is applied to the single bit line 150 and the voltage of 1 V is applied to the second word line 140, a potential difference may be caused on the second transistor 120. The potential difference of the second word line 140 and the single bit line 150 may allow the second transistor 120 to operate; in this case, the first data may be read by sensing a voltage value of the single bit line 150.

According to an embodiment, the storage node 160 may have a plus charge in a state where charges are charged, but the potential difference may not be caused between the second word line 140 and the single bit line 150; in this case, the charge transfer path of the second transistor 120 may be blocked. For convenience of description, in FIG. 2, the description is given as the process of maintaining the first data and the process of reading the first data are distinguished from each other, but in a time period following t2, the process of maintaining the first data and the process of reading the first data may be simultaneously performed by changing the voltages respectively applied to the first word line 130 and the single bit line 150. Also, in FIG. 2, the description is above given as the voltage of - 2V or 1 V is applied to the first word line 130, but the present disclosure is not limited thereto. For example, the first word line 130 may have an arbitrary voltage value for controlling the on/off state of the first transistor 110.

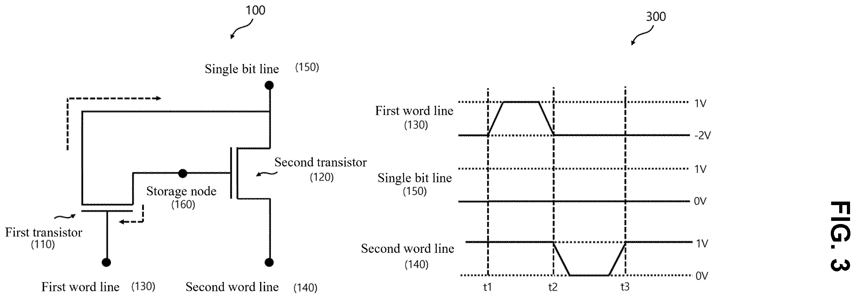

FIG. 3 is a diagram illustrating a process in which the memory cell 100 operates when second data are written or read, according to an embodiment of the present disclosure. In the illustrated example, a graph 300 may show changes of voltages of the first word line 130, the second word line 140, and the single bit line 150 over time.

According to an embodiment, in a time period from t1 to t2, an operation in which second data (e.g., data "0") are written in the memory cell 100 may be performed. Referring to the graph 300, the voltage of 1 V may be applied to the first word line 130. In this case, the first transistor 110 may change to the on state to form a charge transfer path. Also, the voltage of 0 V may be applied to the single bit line 150. In this case, charges present on the storage node 160 may be drained through the first transistor 110, and the storage node 160 may be discharged. According to the above description, the second data may be stored in the memory cell 100 by discharging the charges on the storage node 160.

According to an embodiment, in a time period from t2 to t3, the second data stored in the memory cell 100 may be maintained. Referring to the graph 300, the voltage applied to the first word line 130 may be changed from 1 V to -2 V. Also, the voltage applied to the second word line 140 may be changed from 1 V to 0 V. In this case, because a source-drain potential difference of the second transistor 120 is not maintained, the second transistor 120 may block the charge transfer path. When the charge transfer path is blocked as described above, the storage node 160 may remain in a state where charges are discharged, and thus, there may be maintained a state where the second data are stored in the memory cell 100.

According to an embodiment, in a time period following t3, an operation of reading the second data stored in the memory cell 100 may be performed. Referring to the graph 300, there may be a state where the voltage of 0 V is applied to the single bit line 150, and there may be a state where the voltage applied to the second word line 140 is capable of being changed from 0 V to 1 V. As described above, as the voltage of 0 V is applied to the single bit line 150 and the voltage of 1 V is applied to the second word line 140, a potential difference may be caused on the second transistor 120. The caused potential difference may allow the second transistor 120 to operate; in this case, the second data may be read by sensing a voltage value of the single bit line 150.

For convenience of description, in FIG. 3, the description is given as the process of maintaining the second data and the process of reading the second data are distinguished from each other; however, in a time period following t2, the process of maintaining the second data and the process of reading the second data may be simultaneously performed by changing the voltage to be applied to the first word line 130. Also, in FIG. 3, the description is above given as the voltage of - 2V or 1 V is applied to the first word line 130, but the present disclosure is not limited thereto. For example, the first word line 130 may have an arbitrary voltage value for controlling the on/off state of the first transistor 110.

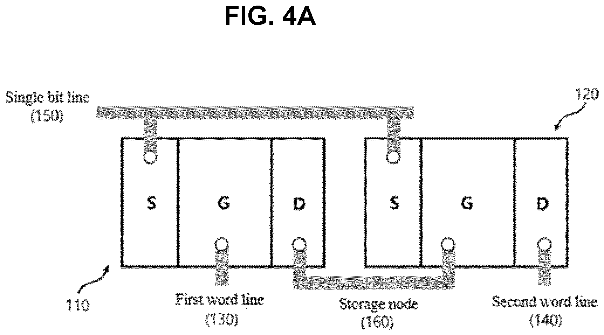

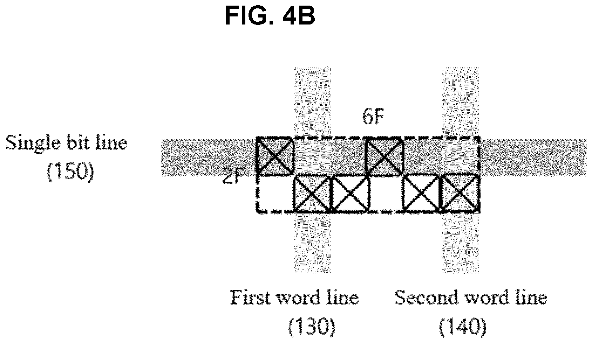

FIGS. 4A and 4B are views illustrating top-view images of a 2T0C-based memory cell according to an embodiment of the present disclosure. As illustrated in FIG. 4A, the 2T0C-based memory cell may be implemented by connecting the first word line 130, the second word line 140, the single bit line 150, and the storage node 160 with two transistors each including a source (S), a gate (G), and a drain (D). Herein, a left transistor may be the first transistor 110 described above, and a right transistor may be the second transistor 120 described above.

According to an embodiment, the first word line 130, the second word line 140, the single bit line 150, and the storage node 160 may be connected to a transistor through via holes. Herein, the via hole which is for electrical connection of metal layers may be implemented by forming a hole in the metal layers and filling the formed hole with a conductive material. In the example illustrated in FIG. 4A, the single bit line 150 may be connected to the sources of the first transistor 110 and the second transistor 120, and the first word line 130 may be connected to the gate of the first transistor 110. Also, the second word line 140 may be connected to the drain of the second transistor 120, and the storage node 160 may be connected to the drain of the first transistor 110 and the gate of the second transistor 120.

According to an embodiment, the first transistor 110 and/or the second transistor 120 may include a channel formed of at least one of oxide, silicon, and organic semiconductor. Herein, the channel may be formed by connecting the source and the drain of the memory cell such that a charge flow is possible. For example, a semiconductor substrate of the first transistor 110 and/or the second transistor 120 may be formed of at least one of oxide semiconductor and organic semiconductor, and the source, the gate, and the drain may be formed on the semiconductor substrate. Also, the channel may be formed by applying a threshold voltage to the gate such that the source and the drain are connected.

According to an embodiment, the first transistor 110 and/or the second transistor 120 may include an insulator formed of at least some of *AIOₓ*, *HfOₓ*, *SiOₓ*, and *HfZrOₓ.* Herein, the insulator may refer to a layer placed between the substrate and the gate such that a current does not flow to the gate of the transistor, and "x" may be a natural number whose range is limited depending on each molecule structure. That is, because the first transistor 110 and/or the second transistor 120 includes an insulator formed of at least some of *AIOₓ*, *HfOₓ*, *SiOₓ*, and *HfZrOₓ*, a leakage current may be appropriately reduced while improving the permittivity.

The feature size is a term which is used as a unit associated with the size of the memory cell in a semiconductor or electronic circuit. The feature size may be mainly used in semiconductor process technologies and may indicate the size of a transistor, a memory cell, or the like being each component. The feature size may refer to the size of the minimum structure which is used in semiconductor process technologies.

According to an embodiment, because the 2T0C-based memory cell uses a single bit line, the feature size of the 2T0C-based memory cell may be smaller than that of a memory cell using two bit lines. As illustrated in FIG. 4B, in the case of using the single bit line 150, the memory cell may have the feature size of 12*F*² defined by a vertical length of 2F and a horizontal length of 6F. That is, the memory cell may have the feature size reduced as much as 6*F*² compared to a conventional memory cell having 18*F*². This may mean that the feature size per bit corresponding to one bit is 12*F*².

An example in which the 2T0C-based memory cell has the feature size of 12*F*² consisting of 2F and 6F is illustrated in FIG. 4, but this is provided as an example. The feature size of the 2T0C-based memory cell may be smaller than that of a memory cell using two bit lines. According to the above configuration, the feature size of the 2T0C-based memory cell may be smaller than that of the existing memory cell; in the case of stacking and using the 2T0C-based memory cells in a plurality of layers, the degree of integration of a memory may be markedly improved in whole.

Meanwhile, a memory device according to an embodiment may include the memory cell 100. In this case, the memory device may be only composed of a plurality of memory cells 100. However, the memory device may include the plurality of memory cells 100 and auxiliary memory cells using two bit lines. That is, the auxiliary memory cell may be a typical memory cell having two bit lines.

A signal applying device may be connected to the first word line 130, the second word line 140, two bit lines, and the single bit lines 150 and may be configured to determine a magnitude of a voltage to be applied to each line and to allow the voltage to be applied.

The memory device may be electrically removable from the signal applying device. A voltage which is applied to a bit line may be determined by the signal applying device connected to the memory device. In this case, when the signal applying device is a signal applying device using a way to apply voltages to two bit lines and is not a signal applying device using a way to determine a voltage to be applied to the single bit line 150, the memory device only including the memory cell 100 may not operate normally.

A processor of the memory device may determine whether the connected signal applying device uses the way to apply voltages to two bit lines or the way to determine a voltage to be applied to the single bit line 150, based on a signal received from the connected signal applying device.

When it is determined that the connected signal applying device uses the way to apply voltages to two bit lines, the memory device may apply voltages two bit lines of the auxiliary memory cell such that two bit line signals are transferred to the auxiliary memory cell using two bit lines.

When it is determined that the connected signal applying device uses the way to apply a voltage to the single bit line 150, the memory device may apply a voltage to the single bit line 150 of the memory cell 100 such that two bit line signals are transferred to the memory cell 100.

As described above, because the memory device according to an embodiment uses the memory cell 100 receiving a bit line signal through a bit line and is also capable of using the auxiliary memory cell receiving two bit lines depending on a situation, the memory device may operate even in any case without limitation of operation, depending on whether a single bit line signal is received or two bit line signals are received.

According to an embodiment, the 2T0C-based memory cell may be in a form capable of being stacked in a plurality of layers. That is, the 2T0C-based memory cells may be stacked in a plurality of layers within a range of the feature size of 12*F*². As described above, when a plurality of memory cells are stacked as a plurality of layers, the same feature size as the case where one memory cell is used may be used, and thus, the degree of integration of the memory may be increased in whole. For example, in the case of stacking two layers, logically, one memory cell may only occupy the area of 6*F*²; in this case, as more layers are stacked, the degree of integration of the memory may be increased.

A memory cell being one layer may have the feature size of 12*F*² per bit by using a single bit line.

That is, when memory cells are stacked in a plurality of layers within the given area of 12*F*², because the memory cells are vertically stacked, the occupied area may be maintained without modification, but the number of bits capable of being processed may increase. Accordingly, in the 2T0C-based memory cells implemented in a plurality of layers, the feature size necessary per bit may decrease.

That is, when the number of layers is "n", in the 2T0C-based memory cells implemented in a plurality of layers, the feature size necessary per bit may be 12*F*²/n.

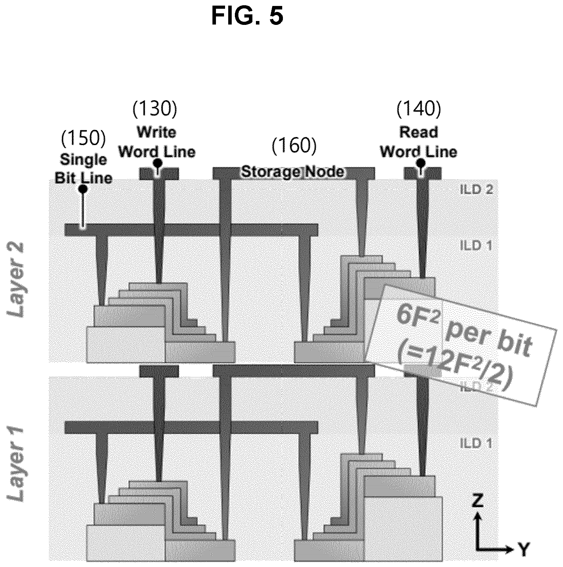

FIG. 5 is a diagram of 2T0C-based memory cells stacked in two layers, according to an embodiment of the present disclosure.

Referring to FIG. 5, memory cells may be capable of being stacked in two layers within a range of the feature size of 12*F*².

In this case, all the 2T0C-based memory cells may have the feature size of 6*F*² per bit. That is, the feature size necessary per bit may be 6*F*².

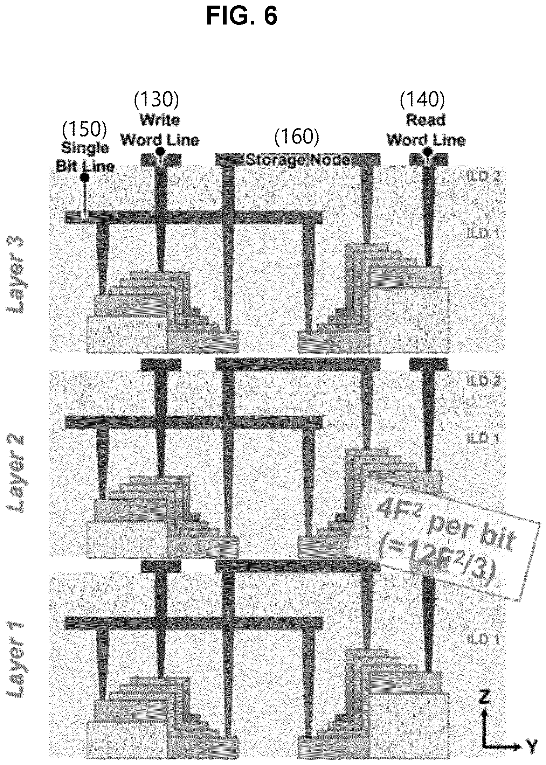

FIG. 6 is a diagram of 2T0C-based memory cells stacked in three layers, according to an embodiment of the present disclosure.

Referring to FIG. 6, memory cells may be capable of being stacked in three layers within a range of the feature size 12*F*² per bit.

In this case, all the 2T0C-based memory cells may have the feature size of 4*F*² per bit. That is, the feature size necessary per bit may be 4*F*².

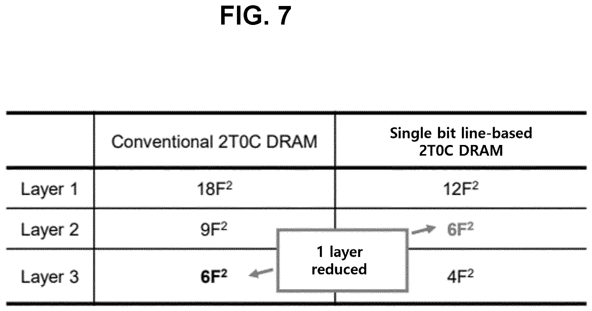

FIG. 7 is a table illustrating a feature size of 2T0C-based memory cells stacked in a plurality of layers and an effect for the number of layers, according to an embodiment of the present disclosure.

Referring to FIG. 7, in the case of a structure in which 2T0C-based memory cells (Single bit line-based 2T0C DRAM) are stacked in a plurality of layers, the area necessary to process a bit value of any one unit may be reduced compared to a conventional memory cell (Conventional 2T0C DRAM), and thus, it is confirmed that the number of stacked layers required decreases.

For example, when the 2T0C-based memory cell with the performance of the feature size of 6*F*² per bit is required, because the conventional memory cell (Conventional 2T0C DRAM) has the performance of the feature size of 18*F*² per bit for each layer, three layers are required.

However, because the 2T0C-based memory cell (Single bit line-based 2T0C DRAM) according to an embodiment has the performance of the feature size of 12*F*² per bit, even though only two layers are stacked, the 2T0C-based memory cell (Single bit line-based 2T0C DRAM) may have the performance of the feature size of 6*F*².

According to the above description, the 2T0C-based memory cell according to an embodiment may implement the same performance even though memory cells are stacked in layers, the number of which is less than that of the conventional memory cell.

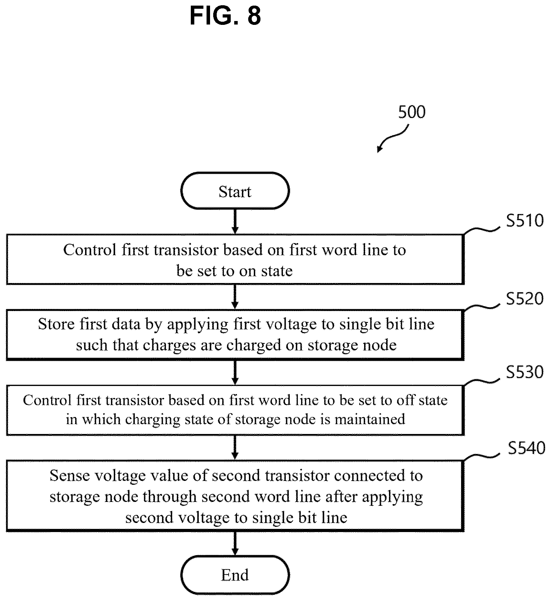

FIG. 8 is a flowchart illustrating an example of an operating method 500 of a 2T0C-based memory cell according to an embodiment of the present disclosure. The operating method 500 of the 2T0C-based memory cell may be performed by a processor (e.g., at least one processor of a computing device). The operating method 500 of the 2T0C-based memory cell may be initiated by controlling, at the processor, a first transistor based on a first word line so as to be set to the on state (S510).

According to an embodiment, the processor may store first data by applying a first voltage to a single bit line such that charges are charged on a storage node (S520). For example, when a voltage of 1 V is applied to the single bit line, charges of the single bit line may be transferred and accumulated to the storage node through the first transistor. According to the above description, the first data may be stored in the memory cell by charging charges on the storage node.

The processor may control the first transistor based on the first word line so as to be set to the off state, and thus, the charging state of the storage node may be maintained (S530). Also, the processor may apply a second voltage to the single bit line such that a second transistor connected to the storage node operates and may then sense a voltage value of the single bit line to read the first data (S540). For example, the processor may read the first data by sensing a change in the voltage value of the single bit line changed while the second transistor is operating in a state where the charges are charged on the storage node.

According to an embodiment, when the charging state of the storage node is maintained, the processor may control the first transistor based on the first word line so as to be set to the on state. Also, the processor may store the second data by applying the second voltage to the single bit line such that charges on the storage node are discharged. That is, the second data may be stored in the memory cell by discharging the charges on the storage node.

The processor may control the first transistor based on the first word line so as to be set to the off state, and thus, the discharging state of the storage node may be maintained. Also, the processor may apply the second voltage to the single bit line such that the second transistor connected to the storage node operates through the second word line and may then sense a voltage value of the single bit line to read the first data. For example, the processor may read the second data by sensing the voltage value of the second transistor in a state where the charges on the storage node are discharged based on a leakage current occurring at the second transistor.

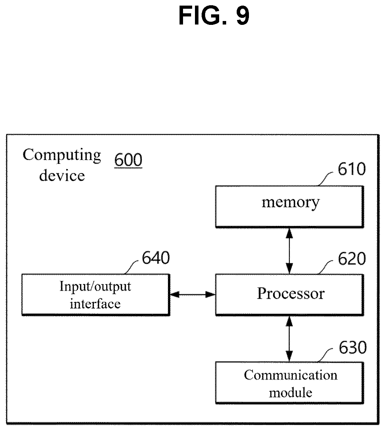

FIG. 9 is a block diagram illustrating an internal configuration of a computing device 600 according to an embodiment of the present disclosure. According to an embodiment, the computing device 600 may refer to an arbitrary device for controlling the above 2T0C-based memory cell and/or a storage device including a plurality of 2T0C-based memory cells. The computing device 600 may include a memory 610, a processor 620, a communication module 630, and an input/output interface 640, and as illustrated in FIG. 9, the computing device 600 may be configured to communicate information and/or data over a network by using the communication module 630.

The memory 610 may include an arbitrary non-transitory computer-readable recording medium. According to an embodiment, the memory 610 may include a random access memory (RAM) or a permanent mass storage device such as a read only memory (ROM), a disk drive, a solid state drive (SSD), or a flash memory. As another example, the permanent mass storage device such as a ROM, an SSD, or a disk drive may be included in the computing device 600 as a separate permanent storage device distinguished from a memory. Also, an operating system and at least one program code may be stored in the memory 610.

The software components may be loaded from a separate computer independent of the memory 610 from to the readable recording medium. The recording medium readable by the separate computer may include a recording medium capable of being directly connected to the computing device 600 and may include, for example, a computer-readable recording medium such as a floptical drive, a disk, a tape, a DVD/CD-ROM drive, or a memory card. As another example, the software components may be loaded into the memory 610 through the communication modules 630, not a computer-readable recording medium. For example, at least one program may be loaded to the memory 610 based on a computer program installed by files provided by developers or by files provided through the communication module 630 by a file distribution system distributing a file for installing an application.

The processor 620 may be configured to process a command of a computer program by performing basic arithmetic, logic, and input and output operations. The command may be provided to the memory 610 or may be provided to any other user terminal (not illustrated) or any other external system by the communication module 630.

The communication module 630 may provide a configuration or a function for allowing the user terminal (not illustrated) and the computing device 600 to communicate with each other over a network, and may provide a configuration or a function for allowing the computing device 600 to communicate with an external system (e.g., a separate cloud system). As an example, a control signal, a command, data, etc. which are provided under control of the processor 620 of the computing device 600 may be transmitted to the user terminal and/or the external system through the communication module 630, the network, and a communication module of the user terminal and/or the external system.

Also, the input/output interface 640 of the computing device 600 may be a means for an interface with a device (not illustrated) for input or output capable of being connected to the computing device 600 or capable of being included in the computing device 600. The input/output interface 640 is illustrated in FIG. 9 as an element implemented independently of the processor 620, but the present disclosure is not limited thereto. For example, the input/output interface 640 may be configured to be included in the processor 620. The computing device 600 may include more components than those of FIG. 9. However, there is no need to clearly illustrate most conventional elements.

The processor 620 of the computing device 600 may be configured to manage, process, and/or store information and/or data received from a plurality of user terminals and/or a plurality of external systems.

The above method and/or various embodiments may be implemented by a digital electronic circuit, computer hardware, firmware, software, and/or a combination thereof. Various embodiments of the present disclosure may be executed by a data processing device, for example, one or more programmable processors and/or one or more computing devices or may be implemented by a computer-readable recording medium and/or a computer program stored in a computer-readable recording medium. The above computer program may be written in any form of programming language including a compiled language or an interpreted language and may be distributed in any form of a standalone program, a module, a subroutine, etc. The computer program may be distributed through one computing device, a plurality of computing devices connected through the same network, and/or a plurality of computing devices distributed to be connected through a plurality of different networks.

The above method and/or various embodiments may be performed by one or more processors configured to execute one or more computer programs which process, store, and/or manage arbitrary functions, etc., by operating based on input data or generating output data. For example, the method and/or various embodiments of the present disclosure may be performed by a special purpose logic circuit such as a field programmable gate array (FPGA) or an application specific integrated circuit (ASIC), and a device and/or a system for performing the method and/or the embodiments of the present disclosure may be implemented as a special purpose logic circuit such as an FPGA or an ASIC.

One or more processors executing a computer program may include a general purpose or special purpose microprocessor and/or one or more processors of an arbitrary kind of digital computing device. A processor may receive a command and/or data from each of a read-only memory and a random access memory or may receive a command and/or data from the read-only memory and the random access memory. In the present disclosure, components of a computing device performing the method and/or the embodiments may include one or more processors for executing instructions and/or one or more memory devices for storing instructions and/or data.

According to an embodiment, a computing device may exchange data with one or more mass storage devices for storing data. For example, a computing device may receive data from a magnetic disk or an optical disk or/and may transmit data to the magnetic disk or the optical disk. A computer-readable storage medium suitable for storing instructions and/or data associated with a computer program may be a memory device in which a plurality of memory cells 100 and a plurality of auxiliary memory cells are arranged and may include an arbitrary type of nonvolatile memory including a semiconductor memory device such as an erasable programmable read-only memory ( EPROM), an electrically erasable PROM ( EEPROM), or a flash memory device, but the present disclosure is not limited thereto. For example, the computer-readable storage medium may include a magnetic disk, a magneto-optical disk, or a CD-ROM and DVD-ROM disk such as an internal hard disk or a removable disk.

To provide interaction with the user, the computing device may include, but is not limited to, a display device (e.g., a cathode ray tube (CRT) or a liquid crystal display (LCD)) for providing or displaying information to the user and a pointing device (e.g., a keyboard, a mouse, or a trackball) capable of allowing the user to provide an input and/or command and the like on the computing device. That is, the computing device may further include arbitrary other types of devices for providing interaction with the user. For example, for interaction with the user, the computing device may provide the user with an arbitrary form of sensory feedback including visual feedback, auditory feedback, and/or tactile feedback. In this regard, the user may provide an input to the computing device through various gestures such as a sight, a voice, and a motion.

In the present disclosure, various embodiments may be implemented in the computing system including a back-end component (e.g., a data server), a middleware component (e.g., an application server), and/or a front-end component. In this case, the components may be interconnected by an arbitrary form of digital data communication such as a communication network or by a medium. For example, the communication network may include a local area network (LAN), a wide area network (WAN), etc.

A computing device based on the example embodiments described in the specification may be implemented by using hardware and/or software configured to interact with the user, in addition to a user device, a user interface (UI) device, a user terminal, or a client device. For example, the computing device may include a portable computing device such as a laptop computer. Additionally or alternatively, the computing device may include, but is not limited to, a personal digital assistant (PDA), a tablet PC, a game console, a wearable device, an IoT (Internet of Things) devices, a virtual reality (VR) device, an AR device, etc. The computing device may further include another type of device configured to interact with the user. In addition, the computing device may include a portable communication device (e.g., a mobile phone, a smartphone, or a wireless cellular phone) suitable for wireless communication over a network such as a mobile communication network. The computing device may be configured to wirelessly communicate with a network server by using wireless communication technologies and/or protocols such as a radio frequency (RF), a microwave frequency (MWF), and/or an infrared ray frequency (IRF).

In the present disclosure, various embodiments including specific structural and functional details are illustrative. Accordingly, embodiments of the present disclosure are not limited to the above description and may be implemented in various different forms. Also, the terms used in the present disclosure are intended to describe some embodiments and are not construed as limiting an embodiment. For example, a singular word and the above may be interpreted as including a plural form unless otherwise clearly indicated in the context.

In the present disclosure, unless otherwise defined, all the terms used in the specification, including technical or scientific terms, have the same meaning as those generally understood by one skilled in the art to which this concept belongs. In addition, commonly used terms such as terms defined in the dictionary should be interpreted as having meanings consistent with those in the context of related technologies.

In various embodiments of the present disclosure, a memory cell may perform the efficient control by adjusting charging and discharging states of a storage node only by using a single bit line or by forming a potential difference with a second word line accurately.

In various embodiments of the present disclosure, a 2T0C-based memory cell may have a feature size smaller than an existing memory cell, and thus, the degree of integration of a memory may be markedly improved in whole in the case of stacking and using the 2T0C-based memory cells in a plurality of layers.

In the specification, even though the present disclosure is described in connection with some embodiments, various modifications and changes may be made without departing from the scope of the present disclosure which may be understood by one skilled in the art. Also, such modifications and alterations shall be considered to fall within the scope of the claims as attached herein.

## Claims

1. A 2T0C-based memory cell comprises:
a first transistor and a second transistor connected through a storage node;
a first word line connected to the first transistor, and configured to control an on/off state of the first transistor through an operation of applying a voltage;
a second word line connected to the second transistor, and configured to control an on/off state of the second transistor such that data stored in the memory cell are read; and
a single bit line connected to the first transistor and the second transistor, and configured to allow the storage node to be charged or discharged depending on a voltage applied to the single bit line.

2. The 2T0C-based memory cell of claim 1, wherein, when the first transistor is controlled by the first word line so as to be set to the on state and a first voltage is provided through the single bit line, first data are stored by charges charged on the storage node.

3. The 2T0C-based memory cell of claim 2, wherein the first data stored on the storage node are maintained when the first transistor is controlled by the first word line so as to be set to the off state.

4. The 2T0C-based memory cell of claim 2 or 3, wherein, when a second voltage is provided through the single bit line and the second voltage is provided through the second word line, the second transistor operates, and the first data are read by sensing a voltage value of the second transistor through the single bit line.

5. The 2T0C-based memory cell of claim 1, wherein, when the first transistor is controlled by the first word line so as to be set to the on state and a second voltage is provided through the single bit line, charges on the storage node are discharged such that second data are stored.

6. The 2T0C-based memory cell of claim 5, wherein, when the first transistor is controlled by the first word line so as to be set to the off state and a first voltage is applied to the second word line, the second data stored on the storage node are maintained.

7. The 2T0C-based memory cell of claim 5 or 6, wherein, when the second voltage is provided through the single bit line and the second voltage is provided through the second word line, the second transistor operates, and the second data are read by sensing a voltage value of the single bit line.

8. The 2T0C-based memory cell of any one of claims 1 to 7, wherein the memory cell has a feature size of 12*F*² per bit by using the single bit line.

9. The 2T0C-based memory cell of claim 8, wherein the memory cell is capable of being stacked in a plurality of layers within a range of the feature size.

10. The 2T0C-based memory cell of claim 8 or 9, wherein the memory cell is capable of being stacked in two layers within a range of the feature size of 12*F*² per bit, and
wherein the 2T0C-based memory cell has a feature size of 6*F*² per bit.

11. The 2T0C-based memory cell of claim 8 or 9, wherein the memory cell is capable of being stacked in three layers within a range of the feature size of 12*F*² per bit, and
wherein the 2T0C-based memory cell has a feature size of 4*F*² per bit.

12. The 2T0C-based memory cell of any one of claims 1 to 11, wherein the first transistor or the second transistor includes a channel formed of at least one of oxide and organic semiconductor.

13. The 2T0C-based memory cell of any one of claims 1 to 12, wherein the first transistor or the second transistor includes an insulator formed of at least some *AIOₓ*, *HfOₓ*, *SiOₓ*, and *HfZrOₓ.*

14. An operating method of a 2T0C-based memory cell which is performed by at least one processor, the method comprising:
controlling a first transistor based on a first word line so as to be set to an on state;
applying a first voltage to a single bit line such that charges are charged on a storage node, wherein first data are stored by the charges on the storage node;
controlling the first transistor based on the first word line so as to be set to an off state, wherein a charging state of the storage node is maintained when the first transistor is in the off state; and
reading the first data by sensing a voltage value of the single bit line after applying a second voltage to the single bit line and applying the second voltage to a second word line such that a second transistor connected to the storage node operates.

15. The method of claim 14, wherein the reading of the first data includes:
reading the first data by sensing the voltage value of the single bit line based on the operation of the second transistor in a state where the charges are charged on the storage node.

16. The method of claim 14 or 15, further comprising:
when a charging state of the storage node is maintained, controlling the first transistor based on the first word line so as to be set to the on state;
storing second data by applying the second voltage to the single bit line such that the charges on the storage node are discharged;
controlling the first transistor based on the first word line so as to be set to the off state, wherein a discharging state of the storage node is maintained when the first transistor is in the off state; and
reading the second data by sensing a voltage value of the single bit line after applying the second voltage to the single bit line and applying the second voltage to the second word line such that the second transistor connected to the storage node operates.

17. A non-transitory recording medium storing a computer program readable by a computer to execute the operating method of the 2T0C-based memory cell according to any one of claims 14 to 16 on the computer.
